Europäisches Patentamt

European Patent Office

Office européen des brevets

(11) Publication number: **0 249 455**
**A1**

## EUROPEAN PATENT APPLICATION

(21) Application number: 87305125.4

(22) Date of filing: 10.06.87

(51) Int. Cl.⁴: **H 01 L 29/14**
**H 01 L 21/203**

(30) Priority: 11.06.86 JP 133660/86

(43) Date of publication of application:
16.12.87 Bulletin 87/51

(84) Designated Contracting States: **DE GB**

(71) Applicant: **HITACHI, LTD.**
**6, Kanda Surugadai 4-chome**
**Chiyoda-ku Tokyo 101 (JP)**

(72) Inventor: **Yamane, Masao**
**Dai-4-Kyoshinryo 14-6, Nishikoigakubo-4-chome**
**Kokubunji-shi (JP)**

**Goto, Shigeo**
**Dai-4-Kyoshinryo 14-6, Nishikoigakubo-4-chome**
**Kokubunji-shi (JP)**

**Mishima, Tomoyoshi**
**12-10, Kamimuneoka-1-chome**
**Shiki-shi (JP)**

**Takahashi, Susumu**
**2196-25, Hirai Hinodemachi**
**Nishitama-gun Tokyo (JP)**

**Morioka, Makoto**
**2196-64, Hirai Hinodemachi**
**Nishitama-gun Tokyo (JP)**

(74) Representative: **Calderbank, Thomas Roger et al**
**MEWBURN ELLIS & CO. 2/3 Cursitor Street**
**London EC4A 1BQ (GB)**

(54) Compound semiconductor structure having graded mole fraction and process for preparation thereof.

(57) With respect to an AlGaAs material as an example, there is disclosed a compound semiconductor structure in the form of superlattice film with graded Al mole fraction, comprising an alternating deposition of an AlGaAs layer containing Al and a GaAs layer containing no Al, the thickness ratio between a pair of said layers being gradually varied in the direction of thickness throughout successive pairs, forming a compound semiconductor structure with substantially graded Al mole fraction. A process for preparing such a semiconductor structure is also disclosed. When the above film is heat-treated, Al in the AlGaAs layer diffuses into the GaAs layer, yielding a film with more smoothly graded Al mole fraction.

FIG. 2

## Description

### COMPOUND SEMICONDUCTOR STRUCTURE HAVING GRADED MOLE FRACTION AND PROCESS FOR PREPARATION THEREOF

This invention relates to a compound semiconductor epitaxial crystal produced by MBE and a process for the preparation thereof. More particularly, it relates to a crystal in the form of superthin film having graded mole fraction and a process for the preparation thereof.

Generally, the epitaxial growth of a compound semiconductor crystal by MBE (molecular beam epitaxy) is characterized principally in that the rate of crystal growth is regulated by controlling the temperature of a molecular beam source, upon which depends the vapor pressure of the atom. In the case of compound semiconductor, the constituent atoms are fed in vapor form into an ultrahigh vacuum from two or more molecular beam sources and are deposited in the form of crystal on a semiconductor substrate crystal placed on a controlled temperature susceptor, the axis of deposited crystal being the same as that of substrate crystal. Thus, the constituent mole fractions in the crystal being prepared, such as, for example, x of $Ga_xAl_{1-x}As$ is determined by fixing each vapor pressure of the molecular beam sources, Ga, Al and As. Since the vapor pressure depends upon the cell temperature, it is necessary for the preparation of a crystal having a graded mole fraction x to vary the cell temperature. Conventionally, in gradually varying the mole fraction from higher region toward lower one, the natural cooling effect has been utilized by switching off the electric source of the heater served as heat source for the cell which accomodated the atom concerned. Since vapor pressure changes exponentially with temperature, a steady temperature control (for example $\pm 0.1°.C$) is required and the above technique has been adopted to meet such a requirement. Fig. 3 represents the relationship between the Al mole fraction of $Al_xGa_{1-x}As$ and the film thickness of the crystal prepared by the above technique.

The crystal growth by the technique of MBE has been discussed in K. Takahashi, "Molecular Beam Epitaxy Technique" (1984) published by Kogyo Chosakai.

There is another technique for establishing a substantially graded mole fraction in a superthin film by using two sets of molecular beam source systems having fixed but different compositions and forming alternately superthin layers, that is, so-called crystal of superlattice structure, to control the average mole fraction of each pair. As an example, the formation of $Al_xGa_{1-x}As$ (from x = 0.3 to x = 0) is described hereunder.

Two sets of molecular beam sources, $Al_{0.3}GaO_{0.7}As$ and GaAs, are necessary. In actual practice, however, the shutters of Ga and As cells are kept open while the shutter of Al cell is opened or closed for a controlled time interval to vary successively the film thickness, resulting in a superlattice. The change in film thickness is allowed to result by making the thickness A of a layer containing the element (Al in this case) whose mole fraction is to be varied and the thickness B of another layer containing none of said element to become identical (A = B) and increasing monotonically the thickness (A + B) of each pair of such layers. In Fig. 4, there is shown the relationship between the Al mole fraction and the epitaxial crystal thickness (proportional to the time of growth). The solid line represents the Al mole fraction of the grown film and the broken line represents the average mole fraction. This technique is described in Electronics Letters, 21, pp. 882 - 884 (1985).

The conventional technique utilizing the natural cooling effect is useful in varying the mole fraction in an epitaxial crystal of several hundreds nm in film thickness because of a relatively long growth time sufficient for the temperature lowering. Thus, it was possible to vary, for example, the Al mole fraction in $Al_xGa_{1-x}As$ from x = 0.3 to x = 0. However, in forming a superthin film of around several tens nm, the change in mole fraction from x = 0.3 to x = 0 was difficult owing to too small a growth time to cause sufficient temperature lowering.

An object of this invention is to provide a compound semiconductor produced by the technique of MBE, which is in the form of superthin film as thin as around several tens nm and having substantially graded mole fraction as well as to provide a process for the preparation of such a compound semiconductor.

The composition of this invention to achieve the above object is as described below.

According to this invention, there is provided a process for preparing a compound semiconductor containing at least three constituent elements and having graded mole fraction by the technique of MBE, characterized in that using two or more sets of molecular beam sources having different mole fractions of elements and forming alternately superthin layers by epitaxial growth while successively varying the thickness ratio of the superthin layers to establish smoothly graded mole fraction. According to this invention, there is also provided a compound semiconductor structure having smoothly graded mole fraction produced by the above process. In this process, while varying the ratio (A/B) of the thickness A of a layer containing the element whose mole fraction is being varied to the thickness B of another layer not containing said element, superthin layers are grown one upon another to construct a superlattice structure of compound semiconductor having substantially graded mole fraction.

Fig. I represents the relation between the mole fraction and the thickness of the film having a superlattice structure formed by depositing superthin layers while gradually decreasing the thickness ratio A/B. The solid line represents the mole fraction as grown film. As shown by the broken line, the average mole fraction in each region decreases with the increase in film thickness, resulting in graded mole fraction. The use of rapid annealing technique to superlattice structure is able to change in the mole fraction from the state as grown film to the state as diffuse the element to be varied. Hence, the element to be varied is redistributed as shown by the broken line, resulting in the more smooth graded mole fraction layers.

Fig. I is in the case of controlling molecular beam source at constant temperature. On the other hand, the invention is allowed to include the case of varying its source in temperature to lower.

It is also possible to obtain more smoothly graded mole fraction by growing an epitaxial crystal of superlattice structure while lowering the temperature of a specific molecular beam source cell by cooling and, at the same time, controlling the time interval of opening or closing the shutter of at least one of the molecular beam sources.

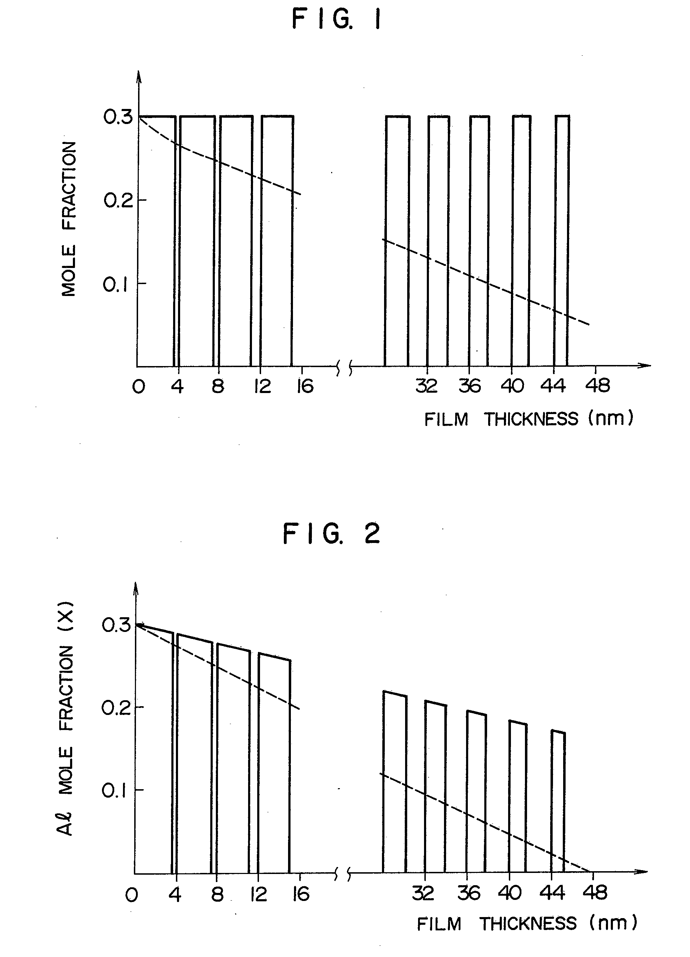

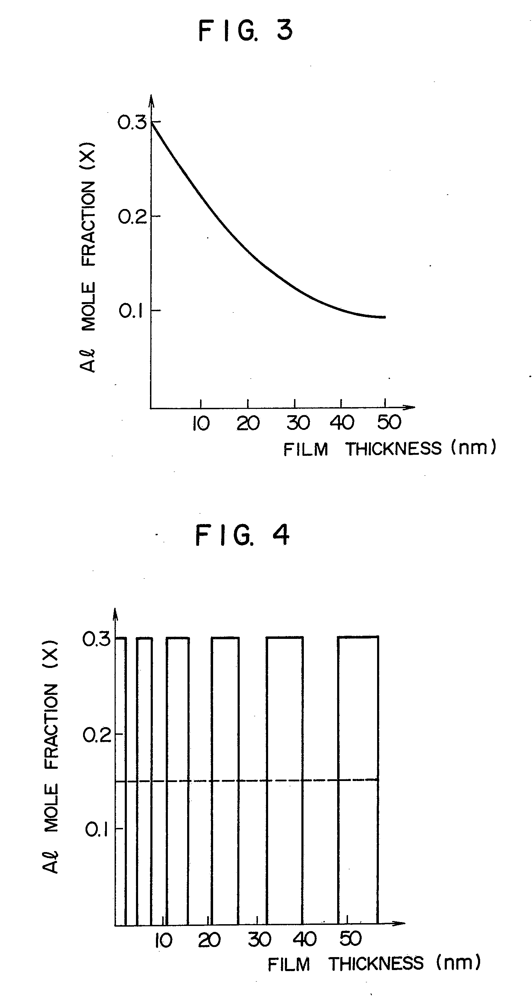

Fig. 2 shows, as an example, the relation between the Al mole fraction and the film thickness of a semiconductor epitaxial crystal of $Al_xGa_{1-x}As$ having a superlattice structure prepared by lowering the temperature of molecular beam source for the element whose mole fraction is being varied and controlling the time interval of opening or closing the shutter of molecular beam source. The solid line represents Al mole fraction of the grown crystal itself. It is shown that owing to the decrease in vapor pressure of Al molecular beam source due to temperature lowering, the Al mole fraction in $Al_xGa_{1-x}As$ decreased when Al cell is opened and that smoothly graded Al mole fraction is obtained by growing alternately GaAs while closing the shutter for Al cell and $Al_xGa_{1-x}As$ while regulating the shutter action. The average Al mole fraction is as shown by broken line. Furthermore, short time annealing causes Al atom to diffuse and distribute as shown by broken line, resulting in more smoothly and continuously graded Al mole fraction.

According to this invention, the mole fraction in superthin film compound semiconductor as thin as around several tens nm prepared by the technique of MBE can be smoothly graded in a wide range (from mole fraction I to 0). Therefore, the invention can be applied to the emitter region or base region of a heterojunction bipolar transistor or to the structural region of a heterojunction field effect transistor, resulting in a decrease in parasitic resistance or an improvement in performance.

**In the drawings:**

Fig. I is a diagram representing the distribution, in the direction of film thickness, of mole fraction of the element whose mole fraction being varied in the crystal of superlattice structure according to this invention.

Fig. 2 is a diagram representing the distribution, in the direction of film thickness, of Al mole fraction in the crystal in one embodiment of this invention.

Fig. 3 is a diagram representing the distribution, in the direction of film thickness, of Al mole fraction in the crystal prepared by utilizing only the conventional effect of temperature lowering.

Fig. 4 is a diagram representing the distribution, in the direction of film thickness, of Al mole fraction in the conventional crystal of superlattice structure.

The MBE apparatus used in this invention is a customary type provided with a crystal growth chamber of ultrahigh vacuum and four cells for molecular beam sources, Ga, As, Al and Si. The semiconductor compound in this Example is $Al_xGa_{1-x}As$. This invention is of course adaptable to other polyatomic compounds such as, for example, $In_xGa_{1-x}As$, $InAs_xP_{1-x}$, $In_xGa_{1-x}As_yP_{1-y}$, $In_xAl_{1-x}As$, $In_xAl_{1-x}P$ and others, which can be prepared by means of a customary MBE apparatus with additional cells and using appropriate semiconductor materials.

The epitaxial crystal growth by the technique of MBE can be controlled in the level of monoatomic layer and so except for the step of crystal growth with varying Al mole fraction, continuous growth can be carried out in normal manner provided that the lattice constant is approximately identical. In this Example, mention will be made of a case in which when the mole fraction is varied from x to y ($I \geq x > y \geq 0$), the composition of the grown layer will change from $Al_xGa_{1-x}A$ to $Al_yGa_{1-y}As$, particularly a case of x = 0.3 and y = 0.

After the substrate has been fixed in place, the temperatures of the substrate and cells of Al, Ga and As are set so that the Al mole fraction may become 0.3, thereby to establish the conditions for the crystal growth until the composition of grown layer becomes $Al_{0.3}Ga_{0.7}As$. Before this point, the shutter for the Al cell is kept open. In the next stage of varying Al mole fraction from 0.3 to 0, the shutter for Al cell is operated to open and close the cell in a unit time span of 20 seconds in the following manner. For instance, the cell is open for I9 seconds during the first 20 seconds, then for I8 seconds during the next 20 seconds, and so on so that the Al mole fraction in the layer grown in 20 seconds may steadily decrease. At the same time the temperature of Al cell is allowed to fall to decrease the Al vapor pressure. Such a 20-second operation is performed I2 times to yield a thin film of about 50 nm in thickness in which Al mole fraction is smoothly graded. Subsequently, continuous growth is allowed to occur with closed Al cell to yield GaAs thin layer.

The resulting film containing Si as dopant is subjected to heat treatment using the technique of short time annealing at 800°C for 30 seconds. As shown by the broken line in Fig. 2, after annealing the Al mole fraction becomes more smoothly graded.

Although the unit time span is 20 seconds in this example, it is not necessary to stick to this time span. Under consideration of the relation between the thickness of monoatomic layer and the rate of crystal growth, the time span should be adjusted so as to obtain smoothly graded mole fraction.

In the stage wherein the time length of open shutter and that of closed shutter become approximately identical, it is effective for making the mole fraction graded as smoothly as possible to decrease the unit time span.

The Si cell is kept at a constant temperature with the shutter kept open throughout the above operation so as to achieve the prescribed doping intensity. The shutter is of course closed in growing undoped layer of $Al_xGa_{1-x}As$ with graded Al mole fraction.

By following the above procedure, there is obtained a thin film, 50 nm in thickness, of $Al_xGa_{1-x}As$ with graded Al mole fraction. In producing a thinner film, it becomes necessary for obtaining more smoothly graded Al mole fraction to reduce the rate of growth by decreasing the cell temperature. It is to be noted, however, that it is necessary for forming a high quality film to increase the vacuum in the growth chamber in proportion to the decrease in growth rate.

Although Si is used as dopant in this Example, other dopants such as Ge for n-type and Be for p-type can also be used. The annealing conditions should be altered with the type of dopant more or less though not greatly. The annealing time can be curtailed by decreasing the unit time span of shutter operation.

In forming an undoped layer with graded mole fraction, there occurs no diffusion of dopant during annealing and, hence, the diffusion of Al by annealing becomes also difficult. To overcome the difficulty, it is necessary to anneal at 900°C for 10 minutes or more.

As described above, it makes difference in annealing conditions whether a dopant is present or not. Such characteristics can be advantageously utilized by using the above film with graded Al mole fraction as a construction member of a selectively doped heterojunction element in such a manner that a necessary device of the element is made smoothly graded by annealing while the undoped layer, which is not to be smoothly graded, is left intact upon annealing.

As described in the foregoing Example, it is possible to form a compound semiconductor superthin film with graded mole fraction and to make the mole fraction more smoothly graded by the way of annealing.

## Claims

1. A compound semiconductor structure in the form of superlattice film comprising alternating deposition of a layer containing an element whose mole fraction is being varied and a layer not containing said element, which is characterized in that the thickness ratio between a pair of said layers varies in the direction of film thickness throughout successive pairs.

2. A compound semiconductor structure according to Claim 1, wherein the superlattice film has an undoped layer.

3. A compound semiconductor structure according to Claim 1 or 2, wherein the superlattice film is an emitter layer or base layer of a heterojunction bipolar transistor.

4. A compound semiconductor structure according to Claim 1 or 2, wherein the superlattice film is a construction member of a heterojunction field-effect transistor.

5. An improved process for preparing a compound semiconductor structure, in which a superlattice film containing at least three constituent elements is formed by the technique of molecular beam epitaxy, wherein the improvement comprises alternately deposition a layer containing an element whose mole fraction is being varied and a layer not containing said element, the thickness ratio between a pair of said layers being varied in the direction of film thickness throughout successive pairs.

6. An improved process for preparing a compound semiconductor structure according to Claim 5, wherein after the epitaxial growth the superlattice film is subject to heat treatment.

7. An improved process for preparing a compound semiconductor structure according to Claim 5 or 6, wherein the epitaxial growth is conducted by manipulating the shutter of the molecular beam source kept at a constant temperature.

8. An improved process for preparing a compound semiconductor structure according to Claim 5 or 6, wherein the temperature of the molecular beam source for the element whose mole fraction is being varied is controlled.

9. An improved process for preparing a compound semiconductor structure according to Claim 6, wherein the heat treatment is conducted at 750° to 850°C for several tens seconds.

10. An improved process for preparing a compound semiconductor structure according to Claim 9, wherein the superlattice film has an undoped layer which remains intact in composition during the heat treatment.

# FIG. 1

MOLE FRACTION vs FILM THICKNESS (nm)

# FIG. 2

Al MOLE FRACTION (X) vs FILM THICKNESS (nm)

0249455

## FIG. 3

## FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| P,X | US-A-4 620 206 (OHTA et al.) * Abstract; figures 7A,7B,18A,18B; column 6, lines 5-27; column 8, lines 14-34 * & JP-A-60 028 268 (pub. 13-02-1985) | 1,2 | H 01 L 29/14 H 01 L 21/203 |
| A | | 5,7 | |
| | --- | | |
| X | JAPANESE JOURNAL OF APPLIED PHYSICS, supplements 17th Conference on Solid State Devices and Materials, 25th - 27th August 1985, pages 197-200, Tokyo, JP; M. OGAWA et al.: "Super-doped structure" * Figure 7; page 199, right-hand column, last paragraph - page 200, left-hand column, line 2 * | 1,2,4 | |
| | | | **TECHNICAL FIELDS SEARCHED (Int. Cl.4)** |
| | | | H 01 L |
| Y | Idem | 3 | |
| | --- | | |
| A | PATENT ABSTRACTS OF JAPAN, vol. 10, no. 259 (E-434)[2315], 4th September 1986; & JP-A-61 84 872 (AGENCY OF INDUSTRIAL SCIENCE AND TECHNOLOGY) 30-04-1986 * Abstract; figures 6-12 * | 1-10 | |
| | --- -/- | | |

The present search report has been drawn up for all claims

| Place of search | Date of completion of the search | Examiner |
|---|---|---|
| THE HAGUE | 15-09-1987 | GORI P. |

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl.4) |
|---|---|---|---|
| Y | EP-A-0 177 374 (FUJITSU LTD) <br> * Figures 9-12; page 10, line 33 - page 11, line 15 * | 3 | |
| A | US-A-3 974 002 (CASEY et al.) <br> * Figures 2,3A; column 6, lines 57-63 * | 5,7,8 | |

TECHNICAL FIELDS
SEARCHED (Int. Cl.4)

The present search report has been drawn up for all claims

| Place of search | Date of completion of the search | Examiner |
|---|---|---|
| THE HAGUE | 15-09-1987 | GORI P. |